# EUROPEAN PATENT APPLICATION

(11) **EP 4 618 726 A1**
(43) Date of publication of application: **17.09.2025**
(21) Application number: 24884662.8
(22) Date of filing: 28.10.2024
(51) Int. Cl.: H10F 10/00

(54) **PHOTOVOLTAIC MODULE**

(30) Priority: 01.11.2023 CN 202322952991 U; 29.04.2024 CN 202420923017 U
(71) Applicant: Longi Green Energy Technology Co., Ltd., Xi'an, Shaanxi 710100 (CN)
(72) Inventor: HE, Zhifu, Xi' an, Shaanxi 710100 (CN); SHI, Haixuan, Xi' an, Shaanxi 710100 (CN); DING, Jiawei, Xi' an, Shaanxi 710100 (CN); WANG, Jing, Xi' an, Shaanxi 710100 (CN); ZHOU, Rengang, Xi' an, Shaanxi 710100 (CN)
(74) Representative: Pfenning, Meinig & Partner mbB
(86) International application number: PCT/CN2024/127785
(87) International publication number: WO 2025/092659

(57) **Abstract**

The present application discloses a photovoltaic module, and relates to the field of photovoltaic technologies, to solve problems that the photovoltaic module has a large visual difference and poor aesthetics. The photovoltaic module includes a cover, a solar cell, and an encapsulation plate that are sequentially stacked from top to bottom. A surface of the solar cell facing the cover has a passivation layer. A refractive index of the passivation layer is greater than or equal to 1.9 and less than or equal to 2.3. A thickness of the passivation layer is greater than or equal to 50 nm and less than or equal to 100 nm. An anti-reflection layer is arranged on the cover, and the anti-reflection layer is located on one side of the cover away from the solar cell. A thickness of the anti-reflection layer is greater than or equal to 100 nm and less than or equal to 230 nm. A refractive index of the anti-reflection layer is greater than or equal to 1.1 and less than or equal to 1.4.

## Description

This application claims priorities to Chinese Patent Application No. 2023229529910, field with the China National Intellectual Administration Property on November 01, 2023 and entitled "BACK CONTACT PHOTOVOLTAIC MODULE", and Chinese Patent Application No. 2024209230173, filed with the China National Intellectual Administration Property on April 29, 2024 and entitled "PHOTOVOLTAIC MODULE", which are incorporated herein by reference in their entities.

### TECHNICAL FIELD

The present application relates to the field of photovoltaic technologies, and in particular, to a photovoltaic module.

### BACKGROUND

A photovoltaic module usually includes a laminate, a junction box, and a frame. The laminate usually includes a cover, a solar cell layer, and a back plate that are sequentially arranged from top to bottom.

In the related art, one side of the solar cell layer facing the cover usually has a passivation layer. Because of the existence of the passivation layer, a solar cell is usually blue or dark blue. In this case, a photovoltaic module manufactured by using the above solar cell has a large visual difference, and has poor aesthetics.

### SUMMARY

An objective of the present application is to provide a photovoltaic module, so that the photovoltaic module visually presents a uniform color, to reduce a visual difference of the photovoltaic module and improve the aesthetics of the photovoltaic module.

To achieve the above objective, the present application provides a photovoltaic module. The photovoltaic module includes a cover, a solar cell, and an encapsulation plate that are sequentially stacked from top to bottom. A surface of the solar cell facing the cover has a passivation layer. A refractive index of the passivation layer is greater than or equal to 1.9 and less than or equal to 2.3. A thickness of the passivation layer is greater than or equal to 50 nm and less than or equal to 100 nm. An anti-reflection layer is arranged on the cover, and the anti-reflection layer is located on one side of the cover away from the solar cell. A thickness of the anti-reflection layer is greater than or equal to 100 nm and less than or equal to 230 nm. A refractive index of the anti-reflection layer is greater than or equal to 1.1 and less than or equal to 1.4.

Compared with the related art, in the photovoltaic module provided in the present application, when the photovoltaic module is manufactured by using the passivation layer and the anti-reflection layer that satisfy the above limitations, the photovoltaic module is visually relatively uniform dark blue or black under the combined action of the passivation layer and the anti-reflection layer. Compared with the photovoltaic module in the related art, the photovoltaic module reduces the visual difference and improves the aesthetics. Further, the thickness and the refractive index of the passivation layer and the thickness and the refractive index of the anti-reflection layer all fall within a specific value range, and are not monotonous absolute values. Therefore, values of the above four limiting conditions may be selected according to an actual situation. In this case, the photovoltaic module may adapt to different application scenarios, so as to enlarge an application range of the photovoltaic module for ease of promotion. In addition, the anti-reflection layer having the above thickness can improve the weather resistance of the cover.

In an embodiment, a refractive index of the passivation layer is greater than or equal to 2.0 and less than or equal to 2.2. The refractive index of the anti-reflection layer is greater than or equal to 1.2 and less than or equal to 1.3.

In an embodiment, the anti-reflection layer is of a stack structure including at least two layers.

In an embodiment, the anti-reflection layer includes a first anti-reflection layer and a second anti-reflection layer that are sequentially stacked, and the second anti-reflection layer is located between the cover and the first anti-reflection layer.

In a case of using the above technical solution, the use of the second anti-reflection layer not only can reduce flatness of a surface of the cover, but also can reduce inconsistency of light reflection directions. Meanwhile, a color difference of the cover can be reduced. Further, the first anti-reflection layer can make the color difference of the cover tend to be zero by using the refractive index of the first anti-reflection layer, so as to reduce or eliminate the color difference obtained after the cover is combined with the solar cell, and improve the aesthetics of the photovoltaic module.

In an embodiment, a thickness of the first anti-reflection layer is greater than a thickness of the second anti-reflection layer.

In an embodiment, the thickness of the first anti-reflection layer is greater than or equal to 80 nm and less than or equal to 150 nm. A thickness of the second anti-reflection layer is greater than or equal to 50 nm and less than or equal to 100 nm.

In an embodiment, a refractive index of the first anti-reflection layer is less than a refractive index of the second anti-reflection layer.

In a case of using the above technical solution, the weather resistance of the cover can be ensured, and an optimized value of coating matching can be obtained. In addition, a stacking thickness of the first anti-reflection layer and the second anti-reflection layer is large. In this case, the weather resistance of the cover can be further improved. In addition, interference of the first anti-reflection layer and interference of the second anti-reflection layer cancel each other, so that the light transmittance can be improved, and a broadband anti-reflection effect is achieved.

In an embodiment, the refractive index of the first anti-reflection layer is greater than or equal to 1.1 and less than or equal to 1.3. The refractive index of the second anti-reflection layer is greater than or equal to 1.3 and less than or equal to 1.5.

In an embodiment, the refractive index of the first anti-reflection layer is greater than or equal to 1.2 and less than or equal to 1.3. The refractive index of the second anti-reflection layer is greater than or equal to 1.4 and less than or equal to 1.5.

In an embodiment, a porosity of the first anti-reflection layer is greater than a porosity of the second anti-reflection layer. In this case, it can be ensured that the refractive index of the first anti-reflection layer is less than the refractive index of the second anti-reflection layer, so as to ensure the weather resistance of the cover and obtain an optimized value of coating matching.

In an embodiment, the porosity of the first anti-reflection layer is greater than or equal to 35% and less than or equal to 60%. In this case, the optical performance of the first anti-reflection layer can be ensured.

In an embodiment, the porosity of the second anti-reflection layer is greater than or equal to 10% and less than or equal to 30%. In this case, the weather resistance of the cover can be further improved.

In an embodiment, a light transmittance of a stack formed by the cover and the anti-reflection layer is greater than or equal to 90%. In this case, it is more beneficial for irradiating light to the solar cell, so as to improve the utilization rate of the solar cell for visible light and improve the photoelectric conversion efficiency of the photovoltaic module.

In an embodiment, the above passivation layer includes a first passivation layer and a second passivation layer that are stacked, and the first passivation layer is located between the cover and the second passivation layer.

In a case of using the above technical solution, compared with using two film layers to regulate a color presented by the solar cell, using one film layer for regulation is more convenient, is easy to implement, and is less difficult.

In an embodiment, one of the first passivation layer and the second passivation layer is an aluminum oxide passivation layer, and the other one of the first passivation layer and the second passivation layer is a silicon nitride passivation layer. A thickness of the aluminum oxide passivation layer is greater than or equal to 5 nm and less than or equal to 10 nm. A refractive index of the aluminum oxide passivation layer is greater than or equal to 1.5 and less than or equal to 1.8. A thickness of the silicon nitride passivation layer is greater than or equal to 50 nm and less than or equal to 80 nm. A refractive index of the silicon nitride passivation layer is greater than or equal to 1.8 and less than or equal to 2.2.

In an embodiment, the first passivation layer is an aluminum oxide passivation layer, and the second passivation layer is a silicon nitride passivation layer.

In an embodiment, the above anti-reflection layer includes at least one of a silicon nitride anti-reflection layer, a silicon oxide anti-reflection layer, and a titanium oxide anti-reflection layer.

In an embodiment, the solar cell is a back contact solar cell.

In an embodiment, the photovoltaic module further includes: the first adhesive film layer and the second adhesive film layer. The first adhesive film layer is located between the cover and the solar cell. The second adhesive film layer is located between the solar cell and the encapsulation plate. The first adhesive film layer and the second adhesive film layer are configured to wrap the solar cell.

In an embodiment, the encapsulation plate is a black organic encapsulation plate or a black enameled encapsulation plate. And/or, the photovoltaic module is an all-black photovoltaic module.

In a case of using the above technical solution, a front side appearance of the photovoltaic module is all black. In this case, the photovoltaic module visually presents a uniform color, thus reducing the visual difference of the photovoltaic module and improving the aesthetics of the photovoltaic module. In addition, the all-black photovoltaic module improves the utilization rate for visible light, thus improving the photoelectric conversion efficiency of the photovoltaic module.

The foregoing descriptions are merely an overview of the technical solutions in the present application. In order that technical means of the present application can be understood more clearly so that the technical solutions can be implemented according to content of the descriptions, and in order that the foregoing and other objectives, features, and advantages of the present application can be understood more clearly, specific embodiments of the present application are described below.

### BRIEF DESCRIPTION OF THE DRAWINGS

The accompanying drawings described herein are used to provide a further understanding of the present application, and form part of the present application. Exemplary embodiments of the present application and descriptions thereof are used to explain the present application, and do not constitute any inappropriate limitation to the present application. In the accompanying drawings:
FIG. 1 is a schematic structural diagram of a photovoltaic module according to an embodiment of the present application;
FIG. 2 is a schematic diagram of a positional relationship between a solar cell and a passivation layer according to an embodiment of the present application;
FIG. 3 is a schematic diagram of a positional relationship between a cover and an anti-reflection layer according to an embodiment of the present application;
FIG. 4 is a schematic diagram of a relationship of incident light, a cover, and an anti-reflection layer according to an embodiment of the present application; and
FIG. 5 is a schematic structural diagram of a solar cell according to an embodiment of the present application.

### Reference numerals in the accompanying drawings:

1: cover plate; 2: solar cell; 20: passivation layer; 200: first passivation layer; 2002: silicon nitride layer; 2001: silicon-oxygen-nitrogen layer; 201: second passivation layer; 3: encapsulation plate; 4: anti-reflection layer; 40: first anti-reflection layer; 41: second anti-reflection layer; 5: first adhesive film layer; and 6: second adhesive film layer.

### DETAILED DESCRIPTION

To make the technical problems to be resolved in the present application, the technical solutions, and beneficial effects more comprehensible, the following further describes the present application in detail with reference to the accompanying drawings and embodiments. It should be understood that the specific embodiments described herein are merely used to explain the present application but are not intended to limit the present application.

It should be noted that, when an element is described as being "fixed on" or "arranged on" another element, the element may be directly located on the another element or indirectly located on the another element. When an element is described as being "connected to" another element, the element may be directly connected to the another element or indirectly connected to the another element.

In addition, terms "first" and "second" are used merely for the purpose of description, and shall not be construed as indicating or implying relative importance or implying a quantity of indicated technical features. Therefore, a feature limited by "first" or "second" may explicitly or implicitly include one or more of the features. In the descriptions of the present application, "a plurality of" means two or more, unless otherwise definitely and specifically limited. Unless otherwise explicitly and specifically limited, "several" means one or more than one.

In the description of the present application, it should be understood that orientation or position relationships indicated by the terms such as "upper", "lower", "front", "rear", "left", and "right" are based on orientation or position relationships shown in the accompanying drawings, and are used only for ease and brevity of illustration and description of the present application, rather than indicating or implying that the mentioned apparatus or element needs to have a particular orientation or needs to be constructed and operated in a particular orientation. Therefore, such terms should not be construed as limiting of the present application.

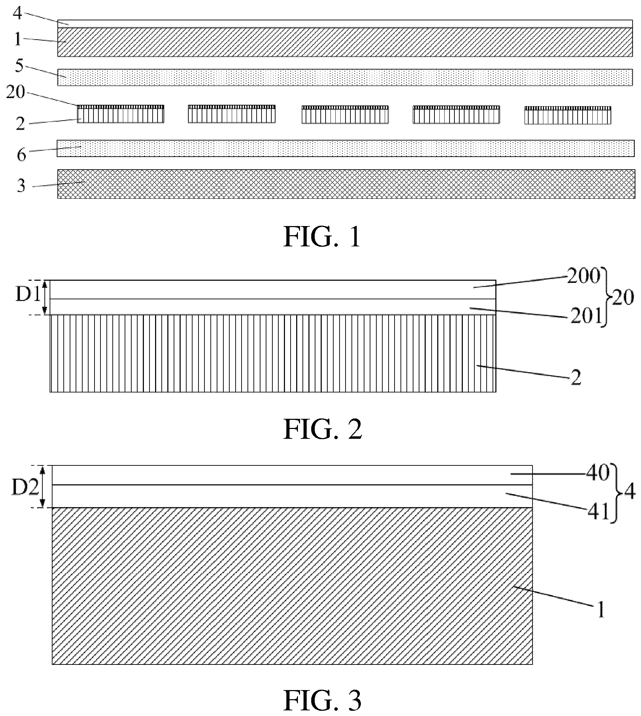

To solve the above technical problems, an embodiment of the present application provides a photovoltaic module. Referring to FIG. 1 to FIG. 3, the photovoltaic module includes a cover 1, a solar cell 2, and an encapsulation plate 3 that are sequentially stacked from top to bottom. A surface of the solar cell 2 facing the cover 1 has a passivation layer 20. A refractive index of the passivation layer 20 is greater than or equal to 1.9 and less than or equal to 2.3. For example, the refractive index of the passivation layer 20 may be 1.9, 1.93, 1.95, 1.98, 2.0, 2.05, 2.08, 2.1, 2.13, 2.16, 2.19, 2.2, 2.23, 2.25, 2.28, 2.3, or the like. Preferably, the refractive index of the passivation layer 20 is greater than or equal to 2.0 and less than or equal to 2.2. For example, the refractive index of the passivation layer 20 may be 2.0, 2.05, 2.08, 2.1, 2.13, 2.16, 2.19, 2.2, or the like. A thickness D1 of the passivation layer 20 is greater than or equal to 50 nm and less than or equal to 100 nm. For example, the thickness D1 of the passivation layer 20 may be 50 nm, 60 nm, 70 nm, 80 nm, 92 nm, 100 nm, or the like. An anti-reflection layer 4 is arranged on the cover 1, and the anti-reflection layer 4 is located on one side of the cover 1 away from the solar cell 2. A thickness D2 of the anti-reflection layer 4 is greater than or equal to 100 nm and less than or equal to 230 nm. For example, the thickness D2 of the anti-reflection layer 4 may be 100 nm, 120 nm, 150 nm, 180 nm, 195 nm, 200 nm, 230 nm, or the like. A refractive index of the anti-reflection layer 4 is greater than or equal to 1.1 and less than or equal to 1.4. For example, the refractive index of the anti-reflection layer 4 may be 1.1, 1.12, 1.15, 1.18, 1.2, 1.21, 1.23, 1.25, 1.28, 1.3, 1.32, 1.36, 1.38, 1.4, or the like. Preferably, the refractive index of the anti-reflection layer 4 is greater than or equal to 1.2 and less than or equal to 1.3. For example, the refractive index of the anti-reflection layer 4 may be 1.2, 1.21, 1.23, 1.25, 1.28, 1.3, or the like. It should be understood that a thickness direction of the passivation layer 20 and a thickness direction of the anti-reflection layer 4 are both consistent with a direction from the cover 1 to the encapsulation plate 3.

Referring to FIG. 1 to FIG. 3, in the photovoltaic module (which is preferably a back contact photovoltaic module) provided in this embodiment of the present application, when the photovoltaic module is manufactured by using the passivation layer 20 and the anti-reflection layer 4 that satisfy the above limitations, the photovoltaic module is visually relatively uniform dark blue or black under the combined action of the passivation layer 20 and the anti-reflection layer 4. Compared with the photovoltaic module in the related art, the photovoltaic module reduces the visual difference and improves the aesthetics. Further, the thickness and the refractive index of the passivation layer 20 and the thickness and the refractive index of the anti-reflection layer 4 all fall within a specific value range, and are not monotonous absolute values. Therefore, values of the above four limiting conditions may be selected according to an actual situation. In this case, the photovoltaic module may adapt to different application scenarios, so as to enlarge an application range of the photovoltaic module for ease of promotion. For example, when the thickness of the passivation layer is 80 nm, and the refractive index of the passivation layer is 2.0, the thickness of the passivation layer needs to be greater than or equal to 120 nm and less than or equal to 180 nm, and the refractive index of the passivation layer needs to be greater than or equal to 1.22 and less than or equal to 1.25. The appearance of the passivation layer is uniform blue black. When the thickness of the passivation layer is 100 nm, and the refractive index of the passivation layer is 2.1, the thickness of the passivation layer needs to be greater than or equal to 150 nm and less than or equal to 200 nm, and the refractive index of the passivation layer needs to be greater than or equal to 1.23 and less than or equal to 1.28. The appearance of the passivation layer is uniform blue black.

Still further, the anti-reflection layer 4 having the above thickness can improve the weather resistance of the cover 1. In addition, the surface of the solar cell 2 facing the cover 1 has the passivation layer 20. That is, a light receiving surface of the solar cell 2 is provided with the passivation layer 20. In this case, the passivation layer may passive a front field, for example, may include field passivation and interface passivation, to protect a front electric field.

In a possible embodiment, referring to FIG. 1 and FIG. 2, the above passivation layer 20 includes a stack structure including at least two passivation layers. However, in consideration of the costs and a manufacturing process, the passivation layer 20 preferably includes a first passivation layer 200 and a second passivation layer 201 that are stacked, and the first passivation layer 200 is located between the cover 1 and the second passivation layer 201. Compared with using two film layers to regulate a color presented by the solar cell 2, using one film layer for regulation is more convenient, is easy to implement, and is less difficult.

In an embodiment, one of the first passivation layer and the second passivation layer is an aluminum oxide passivation layer, and the other one of the first passivation layer and the second passivation layer is a silicon nitride passivation layer. A thickness of the aluminum oxide passivation layer is greater than or equal to 5 nm and less than or equal to 10 nm. For example, the thickness of the aluminum oxide passivation layer may be 5 nm, 6 nm, 7 nm, 8 nm, 9 nm, 10 nm, or the like. A refractive index of the aluminum oxide passivation layer is greater than or equal to 1.5 and less than or equal to 1.8. For example, the refractive index of the aluminum oxide passivation layer may be 1.5, 1.55, 1.6, 1.65, 1.7, 1.75, 1.8, or the like. A thickness of the silicon nitride passivation layer is greater than or equal to 50 nm and less than or equal to 80 nm. For example, the thickness of the silicon nitride passivation layer may be 50 nm, 52 nm, 60 nm, 66 nm, 70 nm, 80 nm, or the like. A refractive index of the silicon nitride passivation layer is greater than or equal to 1.8 and less than or equal to 2.2. For example, the refractive index of the silicon nitride passivation layer may be 1.8, 1.85, 1.9, 1.95, 2.0, 2.05, 2.1, 2.15, 2.2, or the like.

Preferably, the first passivation layer is an aluminum oxide passivation layer, and the second passivation layer is a silicon nitride passivation layer.

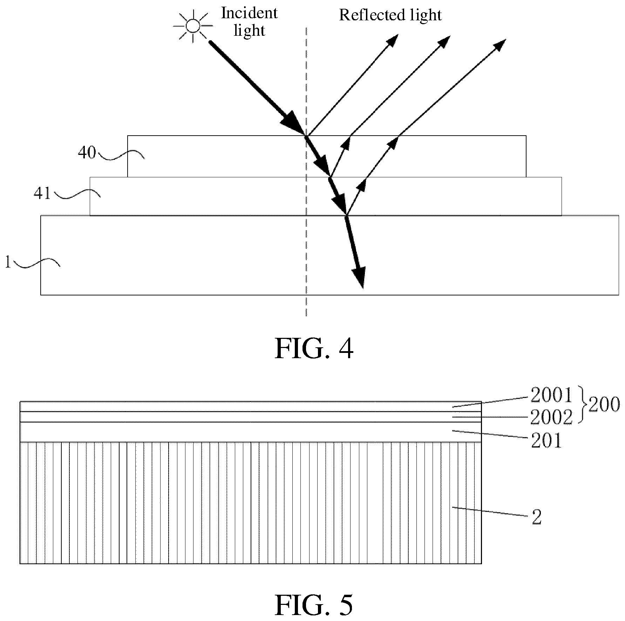

In a possible embodiment, referring to FIG. 5, the first passivation layer 200 is preferably of a two-layer structure. For example, the first passivation layer 200 includes an oxygen-poor silicon nitride layer 2002 (an atomic number ratio of silicon to nitrogen in the silicon nitride layer 2002 is not specified, and the silicon nitride layer 2002 may include a little of oxygen) and an oxygen-rich silicon-oxygen-nitrogen layer 2001 (an atomic number ratio of silicon to oxygen to nitrogen is not specified). A thickness of the silicon nitride layer 2002 is 30 nm to 60 nm. For example, the thickness of the silicon nitride layer 2002 may be 30 nm, 35 nm, 40 nm, 45 nm, 55 nm, 60 nm, or the like. A refractive index of the silicon nitride layer 2002 is 1.9 to 2.3. For example, the refractive index of the silicon nitride layer 2002 may be 1.9, 1.95, 2.0, 2.05, 2.1, 2.15, 2.2, 2.25, 2.3, or the like. A thickness of the silicon-oxygen-nitrogen layer 2001 is 20 nm to 50 nm. For example, the thickness of the silicon-oxygen-nitrogen layer 2001 may be 20 nm, 25 nm, 30 nm, 35 nm, 40 nm, 45 nm, 50 nm, or the like. The refractive index of the silicon-oxygen-nitrogen layer 2001 is 1.5 to 1.9. For example, the refractive index of the silicon-oxygen-nitrogen layer 2001 may be 1.5, 1.55, 1.6, 1.65, 1.7, 1.75, 1.8, 1.85, 1.9, or the like.

Certainly, the silicon nitride layer 2002 may be formed by one-step deposition, or may be formed by multi-step deposition (that is, several layers are deposited and are then stacked to form the silicon nitride layer 2002), and the silicon-oxygen-nitrogen layer 2001 is formed in the same way.

The above anti-reflection layer may be single-layer, or may be at least two-layer. Two possible cases are used as an example for description below. It should be understood that the following description is merely for understanding and is not used for specific limitation.

Example I: The above anti-reflection layer is single-layer. A thickness of the anti-reflection layer is greater than or equal to 105 nm and less than or equal to 135 nm. A refractive index of the anti-reflection layer is greater than or equal to 1.1 and less than or equal to 1.4.

Example II: The anti-reflection layer is of a stack structure including at least two layers. However, in consideration of the costs and a manufacturing process, referring to FIG. 3, the above anti-reflection layer 4 preferably includes a first anti-reflection layer 40 and a second anti-reflection layer 41 that are sequentially stacked, and the second anti-reflection layer 41 is located between the cover 1 and the first anti-reflection layer 40.

In a case of using the above technical solution, the use of the second anti-reflection layer 41 not only can reduce flatness of a surface of the cover 1, but also can reduce inconsistency of light reflection directions. Meanwhile, a color difference of the cover 1 can be reduced. Further, the first anti-reflection layer 40 can make the color difference of the cover 1 tend to be zero by using the refractive index of the first anti-reflection layer, so as to reduce or eliminate the color difference obtained after the cover 1 is combined with the solar cell 2, and improve the aesthetics of the photovoltaic module.

In a possible embodiment, a thickness of the first anti-reflection layer is greater than a thickness of the second anti-reflection layer.

In an embodiment, the thickness of the first anti-reflection layer 40 is greater than or equal to 80 nm and less than or equal to 150 nm. For example, the thickness of the first anti-reflection layer 40 may be 80 nm, 85 nm, 90 nm, 95 nm, 100 nm, 110 nm, 115 nm, 120 nm, 125 nm, 130 nm, 135 nm, 140 nm, 150 nm, or the like. Preferably, the thickness of the first anti-reflection layer 40 is greater than or equal to 100 nm and less than or equal to 130 nm. For example, the thickness of the first anti-reflection layer 40 may be 100 nm, 110 nm, 115 nm, 120 nm, 125 nm, 130 nm, or the like.

In an embodiment, a thickness of the second anti-reflection layer 41 is greater than or equal to 50 nm and less than or equal to 100 nm. For example, the thickness of the second anti-reflection layer 41 may be 50 nm, 55 nm, 60 nm, 70 nm, 72 nm, 76 nm, 80 nm, 85 nm, 90 nm, 95 nm, 100 nm, or the like. Preferably, the thickness of the second anti-reflection layer 41 is greater than or equal to 70 nm and less than or equal to 90 nm. For example, the thickness of the second anti-reflection layer 41 may be 70 nm, 72 nm, 76 nm, 80 nm, 85 nm, 90 nm, or the like.

In a possible embodiment, a refractive index of the first anti-reflection layer is less than a refractive index of the second anti-reflection layer.

In this case, the weather resistance of the cover 1 can be ensured, and an optimized value of coating matching can be obtained. In addition, a stacking thickness of the first anti-reflection layer 40 and the second anti-reflection layer 41 is large. In this case, the weather resistance of the cover 1 can be further improved. In addition, interference of the first anti-reflection layer 40 and interference of the second anti-reflection layer 41 cancel each other, so that the light transmittance can be improved, and a broadband anti-reflection effect is achieved.

In an embodiment, the refractive index of the first anti-reflection layer 40 is greater than or equal to 1.1 and less than or equal to 1.3. For example, the refractive index of the first anti-reflection layer 40 may be 1.1, 1.15, 1.18, 1.2, 1.21, 1.23, 1.25, 1.28, 1.3, or the like. Preferably, the refractive index of the first anti-reflection layer 40 is greater than or equal to 1.2 and less than or equal to 1.3. For example, the refractive index of the first anti-reflection layer 40 may be 1.2, 1.21, 1.23, 1.25, 1.28, 1.3, or the like. The refractive index of the second anti-reflection layer 41 is greater than or equal to 1.3 and less than or equal to 1.5. For example, the refractive index of the second anti-reflection layer 41 may be 1.3, 1.33, 1.36, 1.39, 1.4, 1.42, 1.45, 1.46, 1.48, 1.49, 1.5, or the like. Preferably, the refractive index of the second anti-reflection layer 41 is greater than or equal to 1.4 and less than or equal to 1.5. For example, the refractive index of the second anti-reflection layer 41 may be 1.4, 1.42, 1.45, 1.46, 1.48, 1.49, 1.5, or the like.

The refractive index and the porosity satisfy the following relationship: *n*ₚ² = (*n*² - 1) (1 - *p) +* 1, where np represents a refractive index of a porous thin film; *n* represents a refractive index of SiO₂, *n =* 1.553; and *p* represents a volume percentage of pores in the thin film. In a possible embodiment, a porosity of the first anti-reflection layer 40 is greater than a porosity of the second anti-reflection layer 41. In this case, it can be ensured that the refractive index of the first anti-reflection layer 40 is less than the refractive index of the second anti-reflection layer 41, so as to ensure the weather resistance of the cover 1 and obtain an optimized value of coating matching.

In an embodiment, the porosity of the first anti-reflection layer 40 is greater than or equal to 35% and less than or equal to 60%. For example, the porosity of the first anti-reflection layer 40 may be 35%, 36%, 40%, 45%, 49%, 50%, 55%, 60%, or the like. In this case, the optical performance of the first anti-reflection layer 40 can be ensured. Preferably, the porosity of the first anti-reflection layer 40 is 49%.

In an embodiment, the porosity of the second anti-reflection layer 41 is greater than or equal to 10% and less than or equal to 30%. For example, the porosity of the second anti-reflection layer 41 may be 10%, 12%, 16%, 19%, 20%, 25%, 30%, or the like. In this case, the weather resistance of the cover 1 can be further improved. Preferably, the porosity of the second anti-reflection layer 41 is 19%.

In a preferred embodiment, two or more anti-reflection layers can better adjust a total refractive index and thickness of the anti-reflection layer, so as to match the passivation layer on the solar cell to achieve an optimal visual effect (i.e., having a uniform color and no glare). For example, for two anti-reflection layers, when the thickness of the first anti-reflection layer 40 is 100 nm and the refractive index of the first anti-reflection layer 40 is 1.25, the thickness of the second anti-reflection layer 41 needs to be set to be greater than or equal to 80 nm and less than or equal to 90 nm, and the refractive index of the second anti-reflection layer 41 needs to be set to be greater than or equal to 1.42 and less than or equal to 1.46, to obtain good color uniformity.

In a possible embodiment, referring to FIG. 1 and FIG. 3, a light transmittance of a stack formed by the cover 1 and the anti-reflection layer 4 is greater than or equal to 90%. In this case, it is more beneficial for irradiating light to the solar cell 2, so as to improve the utilization rate of the solar cell 2 for visible light and improve the photoelectric conversion efficiency of the photovoltaic module. Preferably, the light transmittance of the stack formed by the cover 1 and the anti-reflection layer 4 is greater than or equal to 93%.

In a possible embodiment, the above anti-reflection layer includes at least one of a silicon nitride anti-reflection layer, a silicon oxide anti-reflection layer, and a titanium oxide anti-reflection layer. For example, a material of the first anti-reflection layer and a material of the second anti-reflection layer may be at least one of silicon nitride, silicon oxide, or titanium nitride.

In a possible embodiment, the above anti-reflection layer may be formed on the cover through a process such as spattering.

In an embodiment, the cover may be made of soda glass, and a thickness of the cover may be 3.2 mm or 2.0 mm. The refractive index of the cover is approximately 1.5, and a refractive index of air is approximately 1.0. For example, FIG. 4 shows a case in which incident light (for example, the sunlight) sequentially passes through the first anti-reflection layer 40, the second anti-reflection layer 41, and the cover 1, and transmitted light is located in the cover 1. Since the refractive index of the air is less than the refractive index of the first anti-reflection layer less than the refractive index of the second anti-reflection layer less than the refractive index of the cover, it can be learned that from the air to the cover, the refractive indexes sequentially increase, so that a refraction angle of incident light gradually decreases, and the incident light gradually tends to be perpendicular. In this case, the utilization rate of light is increased.

In a possible embodiment, the solar cell is a back contact solar cell. In this way, no grating wires and solder strips block a front side, and the color is more uniform.

In a possible embodiment, referring to FIG. 1, the above photovoltaic module further includes: a first adhesive film layer 5 and a second adhesive film layer 6. The first adhesive film layer 5 is located between the cover 1 and the solar cell 2. The second adhesive film layer 6 is located between the solar cell 2 and the encapsulation plate 3. The first adhesive film layer 5 and the second adhesive film layer 6 are configured to wrap the solar cell.

In an embodiment, the above first adhesive film layer or the above second adhesive film layer may be one of an ethylene-vinyl acetate copolymer (EVA), a polyolefin elastomer (POE), polyvinyl butyral (PVB), and an ionic polymer. The first adhesive film layer or the second adhesive film layer may be made of a same material or may not be made of a different material.

In an embodiment, the first adhesive film layer (or the second adhesive film layer) may be a double-layer adhesive film layer, or may be a three-layer adhesive film layer. The first adhesive film layer (or the second adhesive film layer) may be of an EP structure or an EPE structure. A thickness of the first adhesive film layer (or the second adhesive film layer) is greater than or equal to 0.4 mm and less than or equal to 0.6 mm. A thickness of the first adhesive film layer (or the second adhesive film layer) is greater than a thickness of a solder strip, so as to ensure the reliability of lamination.

In an embodiment, the above photovoltaic module is formed into a solar cell string structure by using a plurality of solar strips, and the solar strips are arranged only on a backlight surface of the solar cell. The solder strip may be flat solder strip, and a cross-sectional size of the solder strip may be 0.35 mm*0.6 mm. A bonding layer is arranged on a surface of the flat solder strip, and the bonding layer may be a tin-lead alloy.

In an embodiment, a ratio of a length of the solar cell is greater than or equal to 180 mm and less than or equal to 220 mm. For example, the length of the solar cell may be 180 mm, 185 mm, 190 mm, 195 mm, 200 mm, 205 mm, 210 mm, 215 mm, 220 mm, or the like. The solar cell is a back contact solar cell, and has a thickness greater than or equal to 100 µm and less than or equal to 180 µm. For example, the thickness of the solar cell layer may be 100 µm, 110 µm, 120 µm, 130 µm, 140 µm, 150 µm, 160 µm, 170 µm, 180 µm, or the like. The front side of the back contact solar cell is not blocked by grating wires and solder strips, so that the back contact solar cell can have a better front side appearance, and has optimal color uniformity.

In an embodiment, when the encapsulation plate is a transparent plate, the photovoltaic module is a double-glass photovoltaic module. When the encapsulation plate is a non-transparent plate, the photovoltaic module is a single-glass photovoltaic module.

In a possible embodiment, the encapsulation plate is a black organic encapsulation plate or a black enameled encapsulation plate. And/or, the photovoltaic module is an all-black photovoltaic module, namely, an all-black photovoltaic module.

In this case, a front side appearance of the photovoltaic module is all black. In this case, the photovoltaic module visually presents a uniform color, thus reducing the visual difference of the photovoltaic module and improving the aesthetics of the photovoltaic module. In addition, the all-black photovoltaic module improves the utilization rate for visible light, thus improving the photoelectric conversion efficiency of the photovoltaic module.

For example, the above black enameled encapsulation plate means that a gridded black enameled layer is arranged on an organic glass plate, and the black enameled layer is located between the solar cell and the organic glass plate, so as to ensure that the front side appearance of the photovoltaic module is all black.

In conclusion, in this embodiment of the present application, light complementation is implemented according to visible light wave bands of different colors, and finally a particular balance is achieved, thereby reducing a color difference between the wave bands. According to the light complementation, the curve of a light transmittance of a single layer has a peak, showing an obvious blue color. Colorless light is adjusted by using the refractive indexes of two layers. The curve has no obvious peak, and no color is presented. For details, refer to Table 1.

**Table 1 Wavelengths of visible light with different colors and complementary light of the visible light**

| λ\ nm | Color | Complementary light |
|---|---|---|
| 400-450 | Purple | Yellow and green |
| 450-480 | Blue | Yellow |
| 480-490 | Green and blue | Orange |
| 490-500 | Blue and green | Red |
| 500-560 | Green | Red and purple |
| 560-580 | Yellow and green | Purple |
| 580-610 | Yellow | Blue |
| 610-650 | Orange | Green and blue |
| 650-760 | Red | Blue and green |

In the descriptions of the above embodiments, the described specific features, structures, materials, or characteristics may be combined in a proper manner in any one or more of the embodiments or examples.

The above descriptions are merely specific embodiments of the present application, but are not intended to limit the protection scope of the present application. Any variation or replacement readily figured out by a person skilled in the art within the technical scope disclosed in the present application shall fall within the protection scope of the present application. Therefore, the protection scope of the present application shall be subject to the protection scope of the claims.

## Claims

1. A photovoltaic module, comprising: a cover, a solar cell, and an encapsulation plate that are sequentially stacked from top to bottom, wherein
a surface of the solar cell facing the cover has a passivation layer; a refractive index of the passivation layer is greater than or equal to 1.9 and less than or equal to 2.3; a thickness of the passivation layer is greater than or equal to 50 nm and less than or equal to 100 nm;
an anti-reflection layer is arranged on the cover, and the anti-reflection layer is located on one side of the cover away from the solar cell;
a thickness of the anti-reflection layer is greater than or equal to 100 nm and less than or equal to 230 nm; and a refractive index of the anti-reflection layer is greater than or equal to 1.1 and less than or equal to 1.4.

2. The photovoltaic module according to claim 1, wherein the refractive index of the passivation layer is greater than or equal to 2.0 and less than or equal to 2.2; and the refractive index of the anti-reflection layer is greater than or equal to 1.2 and less than or equal to 1.3.

3. The photovoltaic module according to claim 1, wherein the anti-reflection layer is of a stack structure comprising at least two layers.

4. The photovoltaic module according to claim 3, wherein the anti-reflection layer comprises a first anti-reflection layer and a second anti-reflection layer that are sequentially stacked, and the second anti-reflection layer is located between the cover and the first anti-reflection layer.

5. The photovoltaic module according to claim 4, wherein a thickness of the first anti-reflection layer is greater than a thickness of the second anti-reflection layer.

6. The photovoltaic module according to claim 5, wherein the thickness of the first anti-reflection layer is greater than or equal to 80 nm and less than or equal to 150 nm; and
the thickness of the second anti-reflection layer is greater than or equal to 50 nm and less than or equal to 100 nm.

7. The photovoltaic module according to claim 4, wherein a refractive index of the first anti-reflection layer is less than a refractive index of the second anti-reflection layer.

8. The photovoltaic module according to claim 7, wherein the refractive index of the first anti-reflection layer is greater than or equal to 1.1 and less than or equal to 1.3; and the refractive index of the second anti-reflection layer is greater than or equal to 1.3 and less than or equal to 1.5.

9. The photovoltaic module according to claim 8, wherein the refractive index of the first anti-reflection layer is greater than or equal to 1.2 and less than or equal to 1.3; and the refractive index of the second anti-reflection layer is greater than or equal to 1.4 and less than or equal to 1.5.

10. The photovoltaic module according to claim 4, wherein a porosity of the first anti-reflection layer is greater than a porosity of the second anti-reflection layer.

11. The photovoltaic module according to claim 10, wherein the porosity of the first anti-reflection layer is greater than or equal to 35% and less than or equal to 60%; and the porosity of the second anti-reflection layer is greater than or equal to 10% and less than or equal to 30%.

12. The photovoltaic module according to claim 1, wherein a light transmittance of a stack formed by the cover and the anti-reflection layer is greater than or equal to 90%.

13. The photovoltaic module according to any one of claims 1 to 12, wherein the passivation layer comprises a first passivation layer and a second passivation layer that are stacked; and the first passivation layer is located between the cover and the second passivation layer.

14. The photovoltaic module according to claim 13, wherein
one of the first passivation layer and the second passivation layer is an aluminum oxide passivation layer, and the other one of the first passivation layer and the second passivation layer is a silicon nitride passivation layer;
a thickness of the aluminum oxide passivation layer is greater than or equal to 5 nm and less than or equal to 10 nm; a refractive index of the aluminum oxide passivation layer is greater than or equal to 1.5 and less than or equal to 1.8;
a thickness of the silicon nitride passivation layer is greater than or equal to 50 nm and less than or equal to 80 nm; and a refractive index of the silicon nitride passivation layer is greater than or equal to 1.8 and less than or equal to 2.2.

15. The photovoltaic module according to claim 13, wherein the first passivation layer is an aluminum oxide passivation layer, and the second passivation layer is a silicon nitride passivation layer.

16. The photovoltaic module according to claim 1, wherein the anti-reflection layer comprises at least one of a silicon nitride anti-reflection layer, a silicon oxide anti-reflection layer, and a titanium oxide anti-reflection layer.

17. The photovoltaic module according to claim 1, wherein the solar cell is a back contact solar cell.

18. The photovoltaic module according to claim 1, further comprising:
a first adhesive film layer, located between the cover and the solar cell; and
a second adhesive film layer, located between the solar cell and the encapsulation plate, wherein
the first adhesive film layer and the second adhesive film layer are configured to wrap the solar cell.

19. The photovoltaic module according to claim 1, wherein the encapsulation plate is a black organic encapsulation plate or a black enameled encapsulation plate; and/or
the photovoltaic module is an all-black photovoltaic module.
